# EUROPEAN PATENT SPECIFICATION

(11) **EP 0 635 582 B1**
(45) Date of publication and mention of the grant of the patent: **20.05.1998**
(21) Application number: 94111316.9
(22) Date of filing: 20.07.1994
(51) Int. Cl.: C23C 14/20, A01K 87/00

(54) **Article having a decorative metal layer**
Gegenstand mit dekorativer Metallbeschichtung
Article présentant un revêtement décoratif métallique

(30) Priority: 23.07.1993 JP 202918/93; 26.01.1994 JP 23521/94
(43) Date of publication of application: 25.01.1995
(60) Divisional application: 97106926.5
(73) Proprietor: DAIWA SEIKO INC., Higashikurume-shi, Tokyo (JP)
(72) Inventor: Takada, Nobuhiro, Iruma-shi, Saitama 358 (JP)
(74) Representative: Grünecker, Kinkeldey, Stockmair & Schwanhäusser Anwaltssozietät

(56) References cited:
- WO-A-94/29127
- DE-A- 3 333 381
- GB-A- 1 094 785
- US-A- 5 028 464
- PATENT ABSTRACTS OF JAPAN vol. 009, no. 171 (C-291) 16 July 1985 & JP-A-60 043 479 (MITSUBISHI JIDOSHA KOGYO KK) 08 March 1985
- PATENT ABSTRACTS OF JAPAN vol. 011, no. 297 (C-448) 25 September 1987 & JP-A-62 089 860 (JAPAN TOBACCO INC;OTHERS: 02) 24 April 1987
- PATENT ABSTRACTS OF JAPAN vol. 016, no. 395 (M-1299) 21 August 1992 & JP-A-04 131 232 (TOTSUKA SOUGIYOU:YUUGEN) 01 May 1992
- PATENT ABSTRACTS OF JAPAN vol. 011, no. 192 (C-429) 19 June 1987 & JP-A-62 013 565 (KANTO SEIKI KK) 22 January 1987
- Römpps Chemie Lexikon,9th edition,pages 301 and 2029
- Dictionary of Scientific and Technical Terms, Mc Graw Hill, page 1713

## Description

The present invention generally relates to an article having a decorative metal layer. Such a decorative metal layer may be used in sporting goods including fishing rods, fishing reels, lures, tackle boxes, boats, golf club shafts, golf club heads, tennis rackets, badminton rackets, bicycle frames, and similar articles.

Japanese Utility Model Unexamined Publication No. Sho-56-117680 discloses a fishing rod in which a carbon fiber layer is formed on the surface of a tubular body. A layer of chromium plating is formed on top of the carbon fiber layer so as to provide protection and a decorative, aesthetically pleasing appearance for the fishing rod.

Since the chromium plating layer directly contacts the carbon fiber layer, the chromium plated layer is prone to electric erosion which may cause the plating to become separated from the carbon fiber. Additionally, since the plating layer is comparatively thick, the weight of the rod is unnecessarily increased, and excessive stress such as that caused by bending of the rod during fishing, produces cracks. Further, since the carbon fiber layer generally presents an uneven surface, the plating layer is apt to also be uneven such that the decorative appearance of the plating layer is not aesthetically pleasing.

DE-A-3333381 discloses synthetic resin articles comprising, in this order, a synthetic resin body, a two-component polyurethane or UV-hardenable paint coating, a metal coating having a thickness of from 2 to 30 nm, and a top coating of a two-component polyurethane or UV-hardenable paint coating.

JP-A-60-043479 relates to a resin molding for ornamentation comprising a base layer of a resin molding of ABS, a bright hot stamping layer of chromium or chromium alloy foil on top of the base layer, and a paint of urethane or acrylic resin on top of the bright hot stamping layer.

JP-A-62-013565 discloses a synthetic resin molding, such as ABS, having provided thereon, in this order, a colored base layer consisting of polyester, a thin metallic film which is vacuum-plated thereon, and a clear top coat film.

It is an object of the present invention to provide an article having a decorative metal layer, said decorative metal layer: 1) having sufficient strength so as not to crack or separate from a contiguous adjacent layer, i.e. being durable; 2) being light in weight; and 3) providing an aesthetically pleasing appearance.

The above object has been solved by providing an article having an exterior surface which is made of fiber-reinforced synthetic resin materials, said article comprising:
an insulating synthetic resin coating layer having a substantially smooth surface on top of the exterior surface,
a several µm thin decorative metal layer on top of said synthetic resin coating layer, and
a protective layer on top of said decorative layer.

Inasmuch as the synthetic resin coating layer is interposed between the surface of the article and the decorative metal layer, it is possible to prevent the decorative metal layer from being electrically eroded, even if the article or the surface of the article is formed of e.g. carbon fibers. The article itself can be formed of synthetic resin with a substantially smooth, mirror-like surface.

The decorative metal layer can be formed by physical vapor deposition (PVD) such as e.g. vacuum deposition, sputtering or ion plating. Consequently, the decorative metal layer is thinner in thickness and higher in impact resistance than that in the case of ordinary plating. Further, a PVD decorative metal layer is lighter in weight, resistant to separation or cracking, and since the substrate to the decorative layer has a substantially smooth surface formed, no uneven portions are produced in this thin decorative metal layer. A transparent or semi-transparent layer is used to protect the thin decorative metal layer.

Figure 1 shows a side view of a fishing rod tube as an example of an article according to the present invention.

Figure 2 is an enlarged partial sectional view taken along the line B-B of the article shown in Figure 1.

Figure 3 is an enlarged partial sectional view similar to that of Figure 2, showing another embodiment of the present invention.

Figure 4 is an enlarged partial sectional view similar to that of Figure 2, showing another embodiment of the present invention.

Figure 5 shows a sectional view taken through an end section of the decorative layer protected by a cover member.

Figure 6 shows an enlarged partial sectional view similar to that of Figure 2 including a scratch or flaw.

Preferred embodiments of the present invention will be described in detail with reference to the drawings.

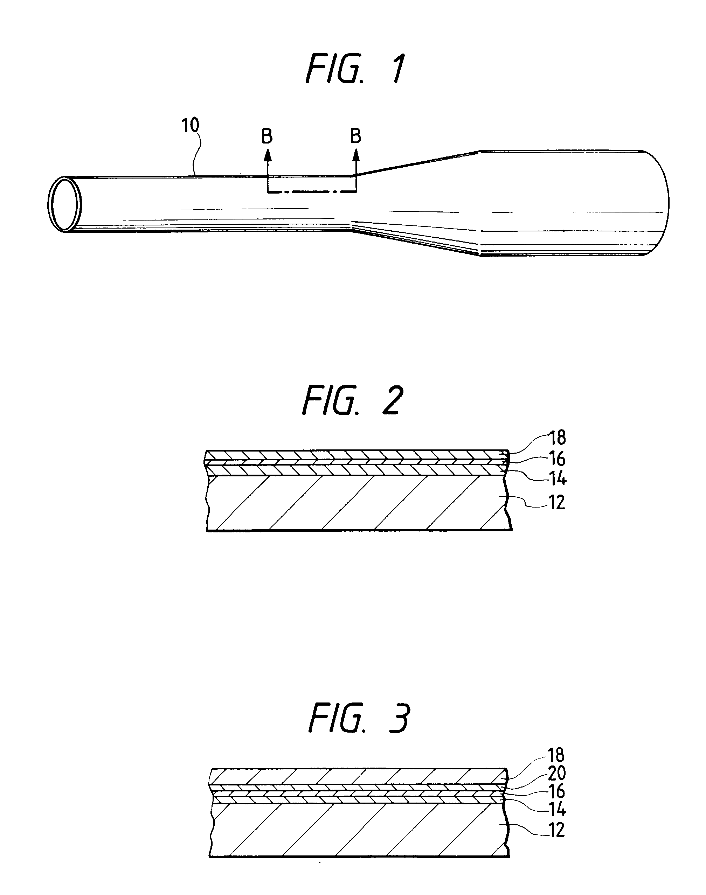

Figure 1 shows a tubular fishing rod body 10 as an example of an article according to the present invention. As shown in Figure 2, an exterior layer 12 of the tubular body 10 is formed by winding a fiber-reinforced prepreg having e.g. carbon fibers as reinforcing fibers. An insulating synthetic resin coating layer 14 is formed on top of the exterior layer 12 by immersion in a synthetic resin, e.g. epoxy resin.

Although it is preferable that the material for the synthetic resin coating layer 14 be identical with the synthetic resin material used in the exterior layer 12, thereby improving the bond between each other, the materials need not be identical. The surface of the coating layer 14 is substantially smooth, like the surface of a mirror, with minimal surface roughness. A light metal, preferably aluminum or titanium, is vapor-deposited on the coating layer 14 by physical vapor deposition (PVD). PVD technics such as vacuum deposition, sputtering and ion plating are used to form a thin decorative metal layer 16. The decorative layer 16 has a thickness of several µm (microns). Since the surface of the synthetic resin coating layer 14, which forms the substrate for the PVD, is substantially smooth like a surface of a mirror, the decorative layer 16 is also substantially smooth. Consequently, consistency of the surface aesthetics is improved.

Since the insulating synthetic resin coating layer 14 is interposed between the exterior layer 12 and the decorative metal layer 16, it is possible to prevent erosion between these layers. Further, the bond between the substrate and the above-mentioned physical vapor deposition layer is improved to eliminate separation and minimize cracking of the decorative metal layer 16. Further, since a PVD layer can be formed which is several µm (micron) thick, a fishing rod or other article can be made light in weight and cracking as a consequence of bending can be virtually eliminated.

A transparent or semi-transparent layer 18 is formed on top of the decorative layer 16 to provide protection. As such, the protective layer 18 is generally thicker than the synthetic resin coating layer 14 or the decorative metal layer 16. The transparent or semi-transparent layer 18 may be colored with a dye, and in combination with the sheen of the decorative metal layer 16, give a deep and rich appearance to the tubular body 10. Further, the protective layer 18 may also be a mat clear layer, a clear layer of paint including beads, a clear layer having a fluorescent color, or a clear layer of paint mixed with particles for preventing stains, odors or adhesion of bacteria.

In addition, although it is not specifically shown in the drawings, the protective layer 18 may also cover the longitudinal ends of the decorative metal layer 16 at the tip and butt ends of the rod body 10. In a structure as shown in Figure 2, if the synthetic resin coating layer 14 has the same or similar color as that of the decorative metal layer 16, a scratch or flaw which may occur on the decorative metal layer 16 when the rod body 10 is accidentally hit on e.g. a rock, is inconspicuous.

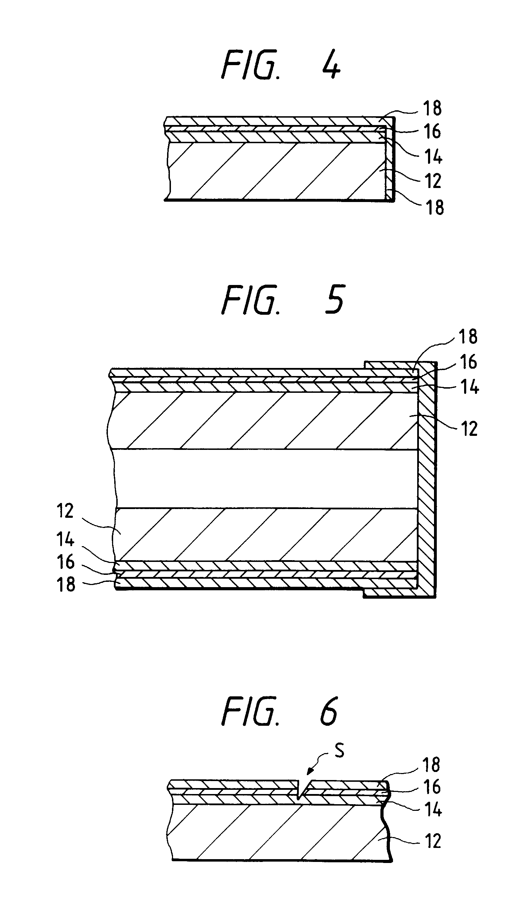

Also the rod body 10 may have a structure for preventing the exposure of the metal decorative layer 16. As illustrated in Figure 4, the protective layer 18 may also extend over the longitudinal ends of the decorative metal layer 16 at the tip and butt ends of the rod body 10 to prevent the longitudinal ends of the decorative metal layer 16 from being exposed outside. Alternatively, a cap member may be securely adhered to each of the tip and butt ends to prevent the exposure of each of the longitudinal ends of the decorative metal layer 16, as illustrated in Figure 5.

In a case where a scratch or flaw ("s" in Figure 6) passes through the protective layer 18, the decorative metal layer 16, being relatively thin, is easily damaged so that the scratch also passes through the decorative metal layer 16 as shown in Figure 6. In such case, if the viewable lower layer, i.e. the synthetic resin coating layer 14 below the metal layer 16, has the same or similar color as that of the metal layer 16, the scratch is not likely to be conspicuous.

Figure 3 shows another embodiment of the present invention, and illustrates an enlarged section of an alternate embodiment according to the present invention. In the same manner as the embodiment shown in Figure 2, an insulating synthetic resin coating layer 14 is formed on the exterior of a tubular body layer 12. A synthetic resin coating layer 14 and a thin decorative metal layer 16 are subsequently formed on top of the tubular body layer 12. In this embodiment, an above-mentioned transparent or semi-transparent color clear layer, a fluorescent color clear layer or the like 20 is formed on top of the decorative metal layer 16, and a transparent or semi-transparent protective layer 18 which is generally thicker than any other layer is formed on top of the layer 20. In this manner, a plurality of protective layers may be formed. Alternatively, a high durability, thin coating may be formed with, for example, an ultraviolet setting paint. Thus, it is possible to provide an article 10 with a deep, bright and aesthetically pleasing appearance. In this case, the protective layer 18 may be omitted, in which case the color clear layer 20 acts as the protective layer.

The color clear layer, or the like 20, need not be formed over the entire surface of the article 10, but may be formed partially. For example, the layer 20 may be applied in different patterns so as to provide decoration with variety. It is also envisioned that the decorative metal layer 16 may be formed partially on the surface of the base rod 10 such as by partially covering the base rod 10 with a suitable member, or by any other method. Further, a structure in which e.g. cloth is to be wound on a grip portion of the article 10 is also within the scope of the present invention.

Further, as mentioned above, the present invention can also be applied to any number of fishing goods including rods, reels, lures, tackle boxes, as well as boats and other supplies; shafts and heads of golf clubs; tennis rackets; badminton rackets; or bicycle frames.

According to the present invention, since an insulating synthetic resin coating layer is formed between an article body and a decorative metal layer, it is possible to prevent erosion even if the article body or a surface portion thereof consists of materials causing electric erosion with metal. In the case of physical vapor deposition, not only the bond with a substrate is superior, but also separation and cracking of the decorative metal layer are virtually eliminated. Further, since a deposition layer formed by physical vapor deposition can be made exceptionally thin, an article such as e.g. a fishing rod can be made light in weight. At the same time, cracking is minimized even if transformation such as bending occurs. Due to the existence of a protective layer, the thin decorative metal layer is protected for the sake of increased durability and to maintain the aesthetic qualities of the decoration for a long time. In addition, since the surface of the synthetic resin coating layer, which is the substrate surface on which deposition occurs, is formed so as to be substantially smooth, the decorative layer is also formed to be smooth so that the aesthetic qualities are further improved. It is therefore possible to provide an article which has high strength to minimize any cracking or separation, is durable, is light in weight and is decorated to achieve an aesthetically pleasing appearance.

## Claims

1. An article having an exterior surface which is made of fiber-reinforced synthetic resin materials, said article comprising:
an insulating synthetic resin coating layer having a substantially smooth surface on top of the exterior surface,
a decorative metal layer having a thickness of several µm or less on top of said synthetic resin coating layer, and
a protective layer on top of said decorative layer.

2. The article according to claim 1, wherein said decorative layer is formed through physical metal vapor deposition.

3. The article according to claim 2, wherein said physical metal vapor deposition includes vacuum deposition.

4. The article according to claim 2, wherein said physical metal vapor deposition includes sputtering.

5. The article according to claim 2, wherein said physical metal vapor deposition includes ion plating.

6. The article according to claim 1, wherein said protective layer is transparent.

7. The article according to claim 1, wherein said protective layer is semi-transparent.

8. The article according to claim 1, wherein said synthetic resin coating layer has the same color as that of said decorative layer.

9. The article according to claim 1, wherein the protective layer is colored with a dye, a mat clear layer, a clear layer of paint including beads, a clear layer having a fluorescent coat color or a clear layer of paint mixed with particles for preventing strains, odors or adhesion of bacteria.

10. The article according to claim 9, wherein the color clear layer is formed on a partial area of the article.

11. The article according to claim 1, wherein the metal decorative layer is partially formed on the area of the article.

12. The article according to claim 1, wherein the protective layer is thicker than each of the other layers.

13. The article according to claim 1, wherein the article is made of a fiber-reinforced prepreg.

## Patentansprüche

1. Gegenstand mit einer äußeren Oberfläche, hergestellt aus faserverstärkten synthetischen Harzmaterialien, wobei der Gegenstand umfaßt:
eine isolierende Überzugsschicht aus einem synthetischen Harz mit einer im wesentlichen glatten Oberfläche, die auf der äußeren Oberfläche aufgebracht ist,
eine dekorative Metallschicht mit einer Dicke von mehreren µm oder weniger, die auf der Überzugsschicht aus dem synthetischen Harz aufgebracht ist, und
eine Schutzschicht, die auf der dekorativen Schicht aufgebracht ist.

2. Gegenstand nach Anspruch 1, wobei die dekorative Schicht mittels eines Verfahrens zum physikalischen Aufdampfen eines Metalls hergestellt wurde.

3. Gegenstand nach Anspruch 2, wobei das Verfahren zum physikalischen Aufdampfen eines Metalls ein Verfahren zur Vakuumabscheidung ist.

4. Gegenstand nach Anspruch 2, wobei das Verfahren zum physikalischen Aufdampfen eines Metalls ein Sputterverfahren ist.

5. Gegenstand nach Anspruch 2, wobei das Verfahren zum physikalischen Aufdampfen eines Metalls ein Ionenplattieren ist.

6. Gegenstand nach Anspruch 1, wobei die Schutzschicht transparent ist.

7. Gegenstand nach Anspruch 1, wobei die Schutzschicht halb-transparent ist.

8. Gegenstand nach Anspruch 1, wobei die Überzugsschicht aus dem synthetischen Harz die gleiche Farbe wie die dekorative Schicht besitzt.

9. Gegenstand nach Anspruch 1, wobei die Schutzschicht eine mit einem Farbstoff gefärbte Schicht, eine matte klare Schicht, eine klare Schicht aus einem Anstrich mit Einschlüssen, eine klare Schicht mit einer fluoreszierenden Farbe oder eine klare Schicht aus einem Anstrich ist, der mit Teilchen vermischt ist, um eine Fleckenbildung, eine Geruchsbildung oder das Anhaften von Bakterien zu verhindern.

10. Gegenstand nach Anspruch 9, wobei die klare Farbschicht auf einem Teil der Oberfläche des Gegenstandes aufgebracht ist.

11. Gegenstand nach Anspruch 1, wobei die dekorative Metallschicht auf einem Teil der Oberfläche des Gegenstandes aufgebracht ist.

12. Gegenstand nach Anspruch 1, wobei die Schutzschicht dicker als jede der anderen Schichten ist.

13. Gegenstand nach Anspruch 1, wobei der Gegenstand aus einem faserverstärkten Prepreg hergestellt wurde.

## Revendications

1. Article ayant une surface extérieure composée de matériaux en résine synthétique renforcés par fibres, ledit article comprenant :
un couche de revêtement en résine synthétique isolante présentant une surface sensiblement lisse sur la partie supérieure de la surface extérieure,
une couche de métal décorative présentant une épaisseur de plusieurs µm ou moins sur la partie supérieure de ladite couche de revêtement en résine synthétique, et
une couche protectrice sur la partie supérieure de ladite couche décorative.

2. Article selon la revendication 1, dans lequel ladite couche décorative est formée par dépôt physique en phase gazeuse de métal.

3. Article selon la revendication 2, dans lequel ledit dépôt physique en phase gazeuse de métal inclut un dépôt sous vide.

4. Article selon la revendication 2, dans lequel ledit dépôt physique en phase gazeuse de métal inclut une pulvérisation cathodique.

5. Article selon la revendication 2, dans lequel ledit dépôt physique en phase gazeuse de métal inclut un plaquage ionique.

6. Article selon la revendication 1, dans lequel ladite couche protectrice est transparente.

7. Article selon la revendication 1, dans lequel ladite couche protectrice est semi-transparente.

8. Article selon la revendication 1, dans lequel ladite couche de revêtement en résine synthétique présente la même couleur que ladite couche décorative.

9. Article selon la revendication 1, dans lequel ladite couche protectrice est colorée par un colorant, une couche claire mate, une couche claire de peinture comportant des perles, une couche claire présentant une couleur de revêtement fluorescente ou une couche claire de peinture mélangée à des particules destinées à empêcher les salissures, les odeurs ou l'adhésion de bactéries.

10. Article selon la revendication 9, dans lequel la couche claire de couleur est formée sur une zone partielle de l'article.

11. Article selon la revendication 1, dans lequel la couche décorative métallique est en partie formée sur la zone de l'article.

12. Article selon la revendication 1, dans lequel la couche protectrice est plus épaisse que chacune des autres couches.

13. Article selon la revendication 1, dans lequel l'article est composé d'un préimprégné renforcé par fibres.
